# FASCICULE DE BREVET EUROPEEN

(11) **EP 2 737 198 B1**
(45) Date de publication et mention de la délivrance du brevet: **18.04.2018**
(21) Numéro de dépôt: 12744060.0
(22) Date de dépôt: 09.07.2012
(51) Int. Cl.: F02N 11/08, H01F 38/00, H02P 1/04

(54) **CIRCUIT DE DEMARREUR DE VEHICULE AUTOMOBILE COMPORTANT UN DISPOSITIF DE REHAUSSEMENT DE TENSION ET DEMARREUR EQUIPE**
ANLASSERSCHALTUNG FÜR KRAFTFAHRZEUG MIT EINER SPANNUNGSSTEIGERUNGSVORRICHTUNG UND ANLASSER DAMIT
MOTOR VEHICLE STARTER CIRCUIT COMPRISING A VOLTAGE RAISING DEVICE AND STARTER SO EQUIPPED

(30) Priorité: 28.07.2011 FR 1156922
(43) Date de publication de la demande: 04.06.2014
(73) Titulaire: Valeo Equipements Electriques Moteur, 94046 Créteil Cedex (FR)
(72) Inventeur: LABBE, Nicolas, F-69003 Lyon (FR); MATT, Jean-Claude, F-21000 Dijon (FR)
(86) Numéro de dépôt international: PCT/FR2012/051610
(87) Numéro de publication internationale: WO 2013/014356

(56) Documents cités:
- EP-A1- 2 233 732
- WO-A1-2005/076293
- US-A1- 2002 023 605

## Description

### DOMAINE TECHNIQUE DE L'INVENTION.

De manière générale, l'invention concerne le domaine des démarreurs pour moteur thermique dans les véhicules automobiles. Plus particulièrement, l'invention concerne la combinaison d'un démarreur et d'un dispositif autorisant un rehaussement de la tension aux bornes de la batterie du véhicule lors de la mise sous tension du démarreur.

### ARRIERE PLAN TECHNOLOGIQUE DE L'INVENTION.

Lors de la mise sous tension d'un démarreur pour assurer le démarrage du moteur thermique du véhicule, il se produit un appel de courant important qui est proche du niveau de courant de court-circuit du démarreur, à savoir, un courant de l'ordre de 1000 Ampères. Ce Phénomène est décrit dans le document US 2002/023605 A1. Cet appel de courant à la mise sous tension du démarreur décroît ensuite en intensité à mesure que l'induit du démarreur, correspondant au rotor de la machine, monte en vitesse.

A ce pic initial de courant correspond une chute conséquente de la tension aux bornes de la batterie. D'autres chutes de tension moins importantes se produisent ensuite pendant la phase de démarrage et correspondent à des passages par des points morts hauts successifs du moteur thermique.

Le développement de démarreurs dits « renforcés » adaptés pour des systèmes d'arrêt/ relance automatique du moteur thermique (systèmes dits « Stop/Start » ou « Stop & Go » en terminologie anglaise) imposent aujourd'hui de nouvelles contraintes aux équipementiers automobiles, relatives au respect de seuils de tension minima de la batterie lors de l'appel de courant à la mise sous tension du démarreur. Ainsi, dans leurs cahiers de charges, les constructeurs automobiles définissent un premier seuil de tension compris habituellement entre 7 et 9 Volt en dessous duquel ne doit pas descendre la tension de batterie. Pour les chutes de tension suivantes, correspondant aux points morts hauts du moteur thermique, la tension de batterie doit rester supérieure à un second seuil de tension compris habituellement entre 8 et 9 Volt. Pendant le démarrage du moteur thermique, la tension du réseau de bord du véhicule reste ainsi à une valeur suffisante pour garantir le fonctionnement attendu des équipements des véhicules.

Les démarreurs renforcés ont généralement une puissance supérieure aux démarreurs classiques de manière à obtenir un démarrage rapide pour davantage de confort des utilisateurs. Il en découle un courant d'appel à la mise sous tension plus élevé et donc une première chute de la tension de batterie qui va au-delà des valeurs habituelles et cela en regard d'exigences élevées. Cela entraîne une réelle difficulté pour le concepteur car il faudrait pour se situer au-dessus en tension de batterie que le démarreur possède des chutes de tension interne si élevées qu'il n'aurait plus alors la puissance nécessaire pour entraîner à vitesse suffisante le moteur thermique à basse température.

Dans la technique antérieure, des solutions ont été proposées au problème exposé ci-dessus. Une première solution connue de l'entité inventive repose sur l'utilisation de convertisseurs électroniques élévateurs de tension afin d'éviter un niveau de tension trop bas sur le réseau de bord. Un inconvénient majeur de ces convertisseurs réside dans les coûts substantiels qu'ils introduisent.

Une autre solution connue propose de commander le démarreur au moyen de deux relais, une temporisation et une résistance de limitation de courant. Dans une première phase de fonctionnement dont la durée est déterminée par la temporisation, une résistance additionnelle est insérée en série dans le circuit de démarrage et limite le pic de courant initial. Dans une seconde phase de fonctionnement, la résistance additionnelle est sortie du circuit de démarrage afin de permettre le passage d'un courant suffisant dans l'induit du démarreur et d'autoriser une montée en vitesse de celui-ci.

Les documents EP2080897A2 et EP2128426A2 décrivent un démarreur du type ci-dessus. Outre l'inconvénient du coût additionnel qu'implique le relais de commande supplémentaire, la temporisation et la résistance de limitation de courant, l'introduction de ce relais supplémentaire, qui comporte des pièces mécaniques mobiles soumises à usure, a un impact négatif sur la tenue du démarreur en termes de nombre de cycles de démarrage que doit pouvoir supporter sans encombre le démarreur. La tenue du démarreur en nombre de cycles de démarrage est une contrainte particulièrement sévère pour les démarreurs destinés à des systèmes Stop/ Start. En effet, il est demandé à de tels démarreurs de tenir environ 300 000 cycles de démarrage, soit dix fois plus que les 30 000 cycles environ demandés aux démarreurs classiques.

Outre les inconvénients exposés ci-dessus, l'utilisation de cette seconde solution de la technique antérieure peut s'avérer inadaptée lorsque la satisfaction à un gabarit de tension contraignant en termes de temps est demandée par le constructeur automobile. Un tel gabarit comporte généralement un palier bas de tension correspondant au premier seuil de tension indiqué ci-dessus et un palier haut de tension correspondant au second seuil de tension. Une rampe de tension montante est également prévue dans le gabarit entre le palier bas et le palier haut.

Les essais réalisés par l'entité inventive, avec les valeurs usuelles des constructeurs pour la durée du palier bas et la pente de la rampe du gabarit, montrent la difficulté qu'il y a avec cette seconde solution de la technique antérieure de rester dans le gabarit. En effet, il a été constaté un risque de franchissement du gabarit au niveau de sa rampe de tension lorsque la tension de batterie, après s'être redressée une fois le pic initial de courant absorbé, chute à nouveau à la fin de la temporisation, le courant traversant l'induit du démarreur augmentant alors sensiblement du fait la sortie de la résistance de limitation de courant du circuit de démarrage. Après ce franchissement, la tension de batterie peut rester sous le gabarit pendant une certaine durée et ne revenir au-dessus du gabarit qu'après la fin de la rampe de tension montante, alors que l'instant de début du palier haut de tension a déjà été atteint.

Dans le but de supprimer les inconvénients indiqués ci-dessus, l'entité inventive a déjà proposé des perfectionnements aux démarreurs existants de la technique antérieure, notamment pour les applications dans des véhicules automobiles de la fonction d'arrêt/ relance automatique du moteur thermique.

Ces perfectionnements ont consisté, de manière générale, à monter un dispositif de filtrage de type inductif en série avec le moteur électrique dans le circuit de puissance du démarreur, de façon à empêcher une chute de la tension de batterie consécutive à un pic de courant produit par la mise en service du moteur électrique.

De nouvelles études menées par l'entité inventive ont permis d'optimiser les modes de réalisation de ces perfectionnements.

### DESCRIPTION GENERALE DE L'INVENTION.

Selon un premier aspect, l'invention concerne une combinaison dans un circuit électrique de démarreur d'un véhicule automobile d'un démarreur et d'un dispositif de rehaussement de tension de batterie, le démarreur comprenant un moteur électrique et un contacteur électromagnétique, le dispositif de rehaussement de tension de batterie étant destiné à empêcher une chute de la tension de batterie consécutive à un pic de courant produit par la mise en service dans un circuit de puissance du démarreur.

Conformément à l'invention, le dispositif de rehaussement de tension de batterie consiste en un dispositif de filtrage de type inductif qui est monté en série avec le moteur électrique dans le circuit de puissance, le dispositif de filtrage comprenant un circuit magnétique avec une pré-polarisation inverse et une carcasse en matériau magnétique comportant une culasse cylindrique et un noyau axial autour duquel sont agencés un circuit d'enroulement primaire destiné à s'insérer en série dans le circuit de puissance et un circuit d'enroulement secondaire en court-circuit.

Selon une forme de réalisation particulière, le dispositif de filtrage est inséré dans le circuit de puissance de démarreur entre une borne positive d'une batterie du véhicule et un contact de puissance du contacteur électromagnétique.

Selon une autre forme de réalisation particulière, le dispositif de filtrage est inséré dans le circuit de puissance de démarreur entre un contact de puissance du contacteur électromagnétique et le moteur électrique.

Selon une caractéristique particulière, le dispositif de filtrage comprend au moins un aimant de polarisation dont les pôles nord et sud sont orientés de manière à introduire la pré-polarisation inverse. De préférence, le dispositif de filtrage comprend en outre une pièce polaire qui est agencée entre le noyau axial et l'aimant de polarisation, un entrefer pouvant être prévu entre la pièce polaire et la culasse.

Selon une autre caractéristique particulière, le dispositif de filtrage comprend au moins un circuit d'enroulement de polarisation. De préférence, le circuit d'enroulement de polarisation est agencé autour du noyau axial, le circuit d'enroulement de polarisation étant bobiné en sens inverse du circuit d'enroulement primaire. Le circuit d'enroulement de polarisation est destiné à être connecté entre une borne négative d'une batterie et un contact de démarrage du véhicule.

Selon un autre aspect, l'invention concerne un démarreur apte à être intégré dans une combinaison telle que décrite brièvement ci-dessus.

Ces quelques spécifications essentielles auront rendu évidents pour l'homme de métier les avantages supplémentaires obtenus grâce à l'optimisation par la société demanderesse de son dispositif de filtrage de type inductif.

Les spécifications détaillées de l'invention sont données dans la description qui suit en liaison avec les dessins ci-annexés. Il est à noter que ces dessins n'ont d'autre but que d'illustrer le texte de la description et ne constituent en aucune sorte une limitation de la portée de l'invention.

### BREVE DESCRIPTION DES DESSINS.

La **Figure 1** est une vue en perspective montrant une combinaison d'un démarreur et d'un dispositif de filtrage de type inductif du genre mis au point antérieurement par la société demanderesse.
La **Figure 2** est un schéma de principe d'un circuit électrique de démarreur comprenant une combinaison telle que montrée sur la **Figure 1****.**
Les **Figures 3a, 3b** et **3c** montrent respectivement la variation du flux magnétique et de l'énergie magnétique dans le dispositif de filtrage en fonction du courant circulant dans le circuit de puissance du démarreur, ainsi que l'évolution du courant en fonction du temps, dans le cas du dispositif de filtrage selon l'invention du type incluant un aimant permanent pour la pré-polarisation inverse (triangles) et dans le cas des dispositifs de filtrage antérieurs (losanges).
La **Figure 4** est une vue en coupe axiale du premier mode de réalisation préféré du dispositif de filtrage selon l'invention.
La **Figure 5** est une vue en coupe axiale du second mode de réalisation préféré du dispositif de filtrage selon l'invention.
La **Figure 6** est un schéma de principe d'un circuit électrique de démarreur comprenant une combinaison d'un démarreur et d'un dispositif de filtrage selon le second mode de réalisation montré sur la **Figure 5****.**

### DESCRIPTION DES MODES DE REALISATION PREFERES DE L'INVENTION.

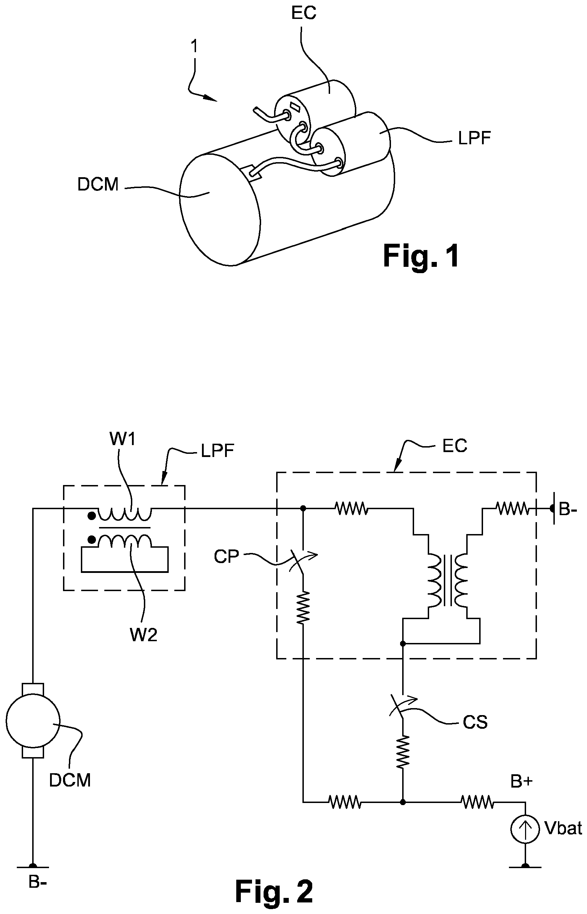

La **Figure 1** montre une combinaison 1 d'un démarreur, comprenant un moteur électrique à courant continu DCM et un contacteur électromagnétique EC, et d'un dispositif de filtrage LPF de type inductif sur lequel ont porté les efforts d'optimisation de la société demanderesse.

Dans cette réalisation, le dispositif de filtrage LPF est fixé mécaniquement à un carter extérieur du démarreur, à proximité du contacteur EC.

Les liaisons électriques entre le dispositif de filtrage LPF, le contacteur EC et le moteur électrique DCM sont montrées sur la **Figure 2****.**

Le dispositif de filtrage LPF est électriquement monté en série entre le contact de puissance CP du contacteur EC et le moteur DCM.

Dans une forme de réalisation alternative (non représentée), le dispositif de filtrage LPF n'est pas intégré dans le démarreur EC, DCM, mais est inséré dans le circuit de puissance entre la borne positive B+ de la batterie et le contact de puissance CP.

Le contacteur EC est ici un contacteur classique de démarreur, à simple contact de puissance CP, et comprend un solénoïde formé d'une bobine d'appel et d'une bobine de maintien.

La fermeture d'un contact de démarrage CS du véhicule commande l'excitation des bobines d'appel et de maintien, et l'activation du démarreur selon un séquencement bien connu de l'homme du métier et qui ne sera pas détaillé ici.

Le fort pic initial de courant mentionné plus haut intervient à la fermeture du contact de puissance CP, lorsque le moteur DCM est alimenté à pleine puissance. La fermeture du contact de puissance CP provoque également la circulation dans le dispositif de filtrage LPF d'un courant de puissance alimentant le moteur DCM.

Comme montré par son schéma électrique représenté à la **Figure 2****,** le dispositif de filtrage LPF est ici un dispositif de type inductif qui est réalisé ici sous la forme d'un transformateur de type cuirassé ayant des enroulements couplés magnétiquement. On notera que selon les applications, une simple inductance aurait pu être utilisée pour former le dispositif de filtrage passe-bas sur lequel ont porté les travaux d'optimisation. La forme de réalisation avec un transformateur permet cependant de disposer de plus de paramètres pour ajuster la réponse en fréquence du dispositif LPF en fonction de l'application. Ainsi, il est possible d'optimiser cette réponse en réglant les inductances des circuits primaire et secondaire W1, W2 et la mutuelle inductance introduite par le couplage entre ces circuits.

Le circuit d'enroulement primaire W1 est celui qui est inséré dans le circuit de puissance du démarreur. Le circuit d'enroulement secondaire W2 est court-circuité.

Typiquement, l'inductance équivalente du dispositif de filtrage inductif LPF est comprise entre 0,1 et 10 mH environ pour des courants ayant un ordre de grandeur de 300 à 1000 A.

L'effet de rehaussement de la tension de batterie obtenu découle du fait qu'à la mise sous tension du moteur DCM, le pic initial de courant est coupé (atténué d'environ la moitié) en raison de la production de forts courants induits dans le circuit secondaire W2 court-circuité, qui s'opposent à la brutale variation de flux magnétique qui les génère.

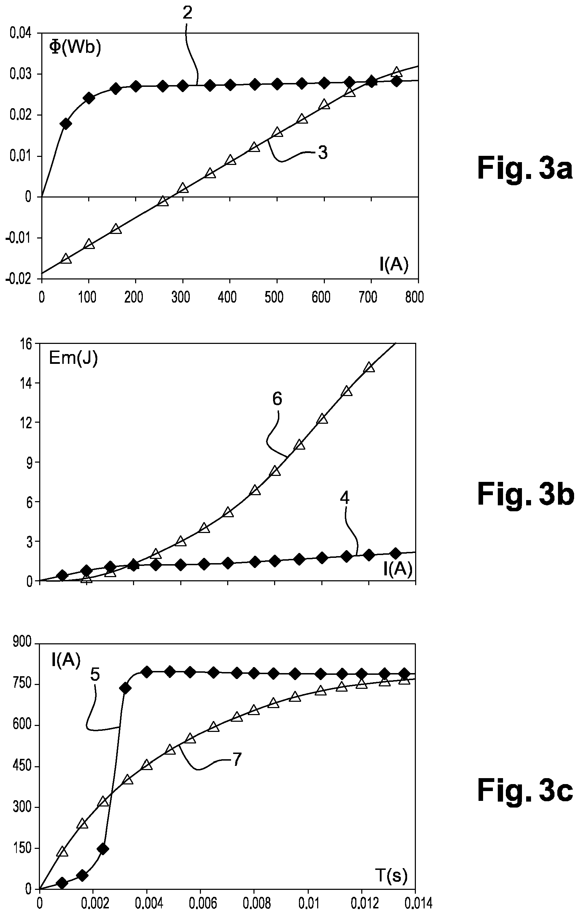

Les **Figures 3a, 3b** et **3c** montrent, à titre d'exemple pour un dispositif de filtrage selon l'invention du type incluant un aimant permanent pour la pré-polarisation inverse, respectivement la variation du flux magnétique et de l'énergie magnétique dans le dispositif de filtrage en fonction du courant circulant dans le circuit de puissance du démarreur, ainsi que l'évolution du courant en fonction du temps, dans le cas du dispositif de filtrage selon l'invention (triangles) et dans le cas des dispositifs de filtrage antérieurs (losanges).

La **Figure 3a** montre la variation du flux magnétique Φ dans un circuit magnétique d'un dispositif de filtrage LPF non optimisé (courbe en losanges 2) et dans le circuit magnétique d'un dispositif de filtrage LPF optimisé (courbe en triangles 3) selon l'invention.

Dans le cas du dispositif de filtrage LPF non optimisé, le flux magnétique Φ croît très rapidement avec l'intensité pour se stabiliser à une valeur maximum.

La **Figure 3b** montre que cette valeur de saturation correspond au stockage d'une faible quantité d'énergie magnétique Em (courbe en losanges 4).

Il s'ensuit que, bien que le pic de courant soit atténué, le courant de puissance I croît très rapidement dès que la saturation du circuit magnétique du dispositif de filtrage LPF non optimisé est atteinte, comme le montre bien la **Figure 3c** (courbe en losanges 5).

Dans le but de retarder l'apparition du phénomène de saturation, le dispositif de filtrage LPF optimisé selon l'invention comprend un circuit magnétique avec une pré-polarisation inverse, c'est-à-dire, une pré-polarisation ayant un effet magnétique opposé à celui du circuit d'enroulement primaire W1.

La **Figure 3a** montre bien que le flux magnétique Φ est négatif pour des courants de puissance inférieurs à environ 300 A (courbe en triangles 3). La croissance du flux magnétique Φ est sensiblement linéaire sur toute la plage de variation du courant de puissance I jusqu'à 800 A, sans que le phénomène de saturation apparaisse.

Dans ce cas, l'énergie magnétique Em emmagasinée atteint des valeurs bien supérieures (courbe en triangles 6 de la **Figure 3b**) aux valeurs correspondant au dispositif de filtrage LPF non optimisé (courbe en losanges 4).

Le résultat de la mise en oeuvre de cette pré-polarisation inverse est une évolution plus lente du courant de puissance I au moment de la mise en service du moteur DCM comme le montre la **Figure 3c** (courbe en triangles 7).

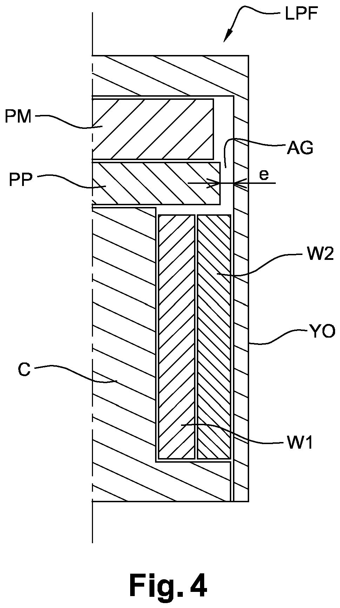

La **Figure 4** montre un premier mode de réalisation préféré du dispositif de filtrage LPF optimisé selon l'invention.

Dans ce premier mode de réalisation préféré, le dispositif LPF optimisé comprend les mêmes éléments essentiels que le dispositif de filtrage LPF non optimisé, c'est-à-dire une carcasse C, YO en matériau magnétique tel que l'acier, et des circuits d'enroulement primaire W1 et secondaire W2 en cuivre.

La carcasse comprend une culasse cylindrique YO et un noyau axial C autour duquel sont agencés les circuits d'enroulement W1, W2.

Le circuit d'enroulement primaire W1 est destiné à s'insérer en série dans le circuit de puissance et le circuit d'enroulement secondaire W2 est en court-circuit.

Une pré-polarisation inverse du circuit magnétique C, YO est obtenue au moyen d'un aimant de polarisation PM, de préférence un ferrite ou un aimant néodyme-fer-bore, dont les pôles nord et sud sont orientés de manière adéquate, c'est-à-dire, de manière à avoir un effet magnétique opposé à celui du circuit d'enroulement primaire W1.

Une pièce polaire PP est agencée entre le noyau axial C et l'aimant de polarisation PM de manière à concentrer le flux magnétique de celui-ci et à la protéger contre la désaimantation.

Un entrefer AG, d'épaisseur ajustable e, entre la pièce polaire PP et la culasse YO permet l'ajustement de la protection de l'aimant de polarisation PM contre la désaimantation.

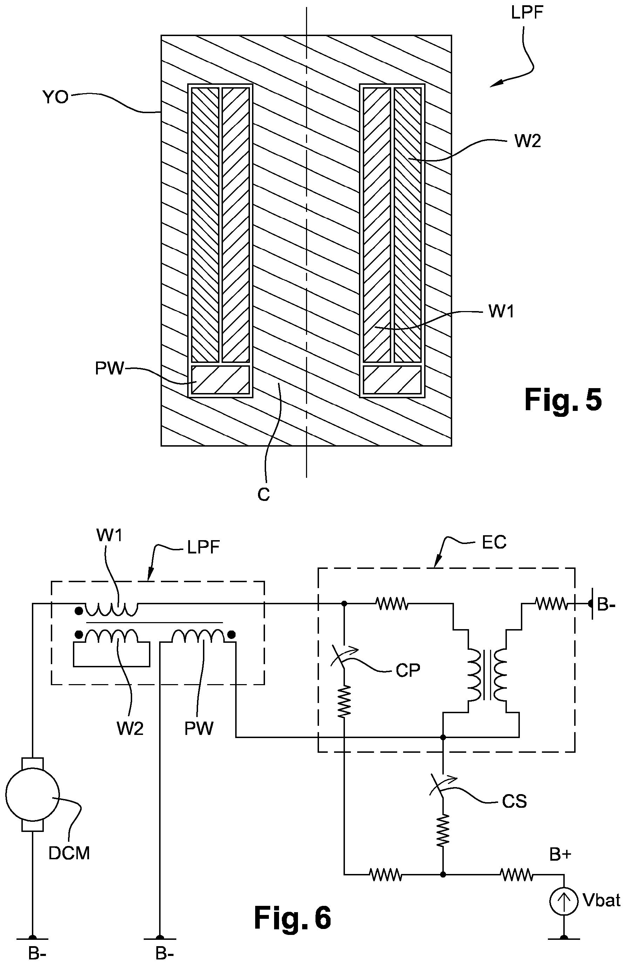

La **Figure 5** montre un second mode de réalisation préféré du dispositif de filtrage LPF optimisé selon l'invention.

Dans ce second mode de réalisation préféré, le dispositif LPF optimisé comprend également les mêmes éléments essentiels que le dispositif de filtrage LPF non optimisé, c'est-à-dire une carcasse C, YO en matériau magnétique tel que l'acier, et des circuits d'enroulement primaire W1 et secondaire W2 en cuivre.

Au lieu d'un aimant de polarisation PM, un circuit d'enroulement de polarisation PW est bobiné en sens inverse du circuit d'enroulement primaire W1 autour du noyau axial C à une première extrémité des enroulements primaire et secondaire W1,W2. Selon une variante, le circuit d'enroulement de polarisation PW est formé de deux parties bobinées autour du noyau axial C respectivement à la première extrémité et la seconde extrémité opposée des enroulements primaire et secondaire.

Les liaisons électriques entre le dispositif de filtrage LPF optimisé dans ce second mode de réalisation préféré, le contacteur EC et le moteur électrique DCM sont montrées sur la **Figure 6****.**

Le circuit d'enroulement de polarisation PW est connecté entre la borne négative B- de la batterie et le contact de démarrage CS du véhicule.

Ce câblage permet l'établissement d'un courant en régime permanent dans le circuit d'enroulement de polarisation PW en même temps que l'excitation des bobines d'appel et de maintien du contacteur électromagnétique EC, c'est-à-dire environ 25 ms avant la fermeture du circuit de puissance par le contact de puissance CP.

La pré-polarisation du circuit magnétique YO, C avant l'établissement en transitoire du courant de puissance I permet de bénéficier d'une plus grande variation d'induction ce qui permet de retarder la saturation (par exemple, l'amplitude de la variation de flux magnétique Φ peut atteindre deux fois la valeur de saturation). Le moteur électrique DCM peut ainsi atteindre une vitesse de rotation plus élevée, et génère donc une force contre-électromotrice plus élevée, au moment de la saturation, ce qui contribue à limiter le courant de puissance I.

Ce second mode de réalisation permet la réalisation d'un dispositif de filtrage LPF optimisé de grande efficacité. On notera que l'entrefer AG n'est ici pas nécessaire pour la protection de l'aimant de polarisation PM contre la désaimantation.

Comme il va de soi, l'invention ne se limite pas aux seuls modes d'exécution préférentiels décrits ci-dessus.

Notamment, l'aimant de polarisation PM est, en variante, agencé en un autre point du circuit magnétique YO, C que celui montré sur la **Figure 4****.** D'autres variantes possibles comprennent plusieurs exemplaires de cet aimant de polarisation PM.

La disposition relative des circuits d'enroulement primaire et secondaire W1, W2 et du circuit d'enroulement, voire des circuits d'enroulement, de polarisation PW est, alternativement, différente de celle représentée sur la **Figure 5****.**

Le branchement électrique du circuit d'enroulement de polarisation PW représenté sur la **Figure 6** n'est aussi qu'un exemple que l'homme de métier modifiera facilement en fonction des besoins.

De plus, on notera que dans certains modes de réalisation le circuit d'enroulement secondaire W2 pourra avantageusement être constitué d'un tube conducteur (par exemple en cuivre ou en aluminium) concentrique au circuit d'enroulement primaire W1, et situé à l'extérieur ou à l'intérieur de ce dernier.

L'invention embrasse donc de nombreuses variantes possibles de réalisation dans la limite de l'objet des revendications ci-après.

## Revendications

1. Combinaison (1) dans un circuit électrique de démarreur d'un véhicule automobile d'un démarreur (DCM, EC) et d'un dispositif de rehaussement de tension de batterie (LPF), ledit démarreur (DCM, EC) comprenant un moteur électrique (DCM) et un contacteur électromagnétique (EC), ledit dispositif de rehaussement de tension de batterie (LPF) étant destiné à empêcher une chute de la tension de batterie (Vbat) consécutive à un pic de courant produit par la mise en service dans un circuit de puissance dudit démarreur (DCM,EC), **caractérisée en ce que** ledit dispositif de rehaussement de tension de batterie (LPF) consiste en un dispositif de filtrage de type inductif (LPF) qui est monté en série avec ledit moteur électrique (DCM) dans ledit circuit de puissance, ledit dispositif de filtrage comprenant un circuit magnétique (YO, C) avec une pré-polarisation inverse et une carcasse (YO, C) en matériau magnétique comportant une culasse cylindrique (YO) et un noyau axial (C) autour duquel sont agencés un circuit d'enroulement primaire (W1) destiné à s'insérer en série dans ledit circuit de puissance et un circuit d'enroulement secondaire (W2) en court-circuit.

2. Combinaison selon la revendication 1, **caractérisée en ce que** ledit dispositif de filtrage (LPF) est inséré dans ledit circuit de puissance de démarreur (DCM, EC) entre une borne positive (B+) d'une batterie dudit véhicule et un contact de puissance (CP) dudit contacteur électromagnétique (EC).

3. Combinaison selon la revendication 1, **caractérisée en ce que** ledit dispositif de filtrage (LPF) est inséré dans ledit circuit de puissance de démarreur (DCM, EC) entre un contact de puissance (CP) dudit contacteur électromagnétique (EC) et ledit moteur électrique (DCM).

4. Combinaison selon l'une quelconque des revendications 1 à 3, **caractérisée en ce que** ledit dispositif de filtrage (LPF) comprend au moins un aimant de polarisation (PM) dont les pôles nord et sud sont orientés de manière à introduire ladite pré-polarisation inverse.

5. Combinaison selon la revendication 4, **caractérisée en ce que** ledit dispositif de filtrage (LPF) comprend en outre une pièce polaire (PP) qui est agencée entre ledit noyau axial (C) et ledit aimant de polarisation (PM).

6. Combinaison selon la revendication 5, **caractérisée en ce qu'**il existe un entrefer (AG) entre ladite pièce polaire (PP) et ladite culasse (YO).

7. Combinaison selon l'une quelconque des revendications 1 à 3, **caractérisée en ce que** ledit dispositif de filtrage (LPF) comprend au moins un circuit d'enroulement de polarisation (PW).

8. Combinaison selon la revendication 7, **caractérisée** en que ledit circuit d'enroulement de polarisation (PW) est agencé autour dudit noyau axial (C), ledit circuit d'enroulement de polarisation (PW) étant bobiné en sens inverse dudit circuit d'enroulement primaire (W1).

9. Combinaison selon la revendication 8, **caractérisée en ce que** ledit circuit d'enroulement de polarisation (PW) est destiné à être connecté entre une borne négative (B-) d'une batterie et un contact de démarrage (CS) dudit véhicule.

## Patentansprüche

1. Kombination (1) in einer elektrischen Anlasserschaltung eines Kraftfahrzeugs eines Anlassers (DCM, EC) und einer Batteriespannungssteigerungsvorrichtung (LPF), wobei der Anlasser (DCM, EC) einen Elektromotor (DCM) und ein elektromagnetisches Schütz (EC) aufweist, wobei die Batteriespannungssteigerungsvorrichtung (LPF) dazu bestimmt ist, einen Abfall der Batteriespannung (Vbat) nach einer Stromspitze zu verhindern, die durch die Inbetriebnahme in einem Leistungskreis des Anlassers (DCM, EC) erzeugt wird, **dadurch gekennzeichnet, dass** die Batteriespannungsverstärkungsvorrichtung (LPF) aus einer induktiven Filtervorrichtung (LPF) besteht, die mit dem Elektromotor (DCM) in dem Leistungskreis in Reihe geschaltet ist, wobei die Filtervorrichtung einen Magnetkreis (YO, C) mit einer umgekehrten Vorpolarisation und ein Gehäuse (YO, C) aus magnetischem Material aufweist, umfassend ein zylindrisches Joch (YO) und einen axialen Kern (C), um den herum eine Primärwicklungsschaltung (W1), die dazu bestimmt ist, in dem Leistungskreis in Reihe geschaltet zu werden, und eine kurzgeschlossene Sekundärwicklungsschaltung (W2) angeordnet sind.

2. Kombination nach Anspruch 1, **dadurch gekennzeichnet, dass** die Filtervorrichtung (LPF) in dem Leistungskreis des Anlassers (DCM, EC) zwischen einer positiven Anschlussklemme (B+) einer Batterie des Fahrzeugs und einem Leistungskontakt (CP) des elektromagnetischen Schützes (EC) eingefügt ist.

3. Kombination nach Anspruch 1, **dadurch gekennzeichnet, dass** die Filtervorrichtung (LPF) in dem Leistungskreis des Anlassers (DCM, EC) zwischen einem Leistungskontakt (CP) des elektromagnetischen Schützes (EC) und dem Elektromotor (DCM) eingefügt ist.

4. Kombination nach einem der Ansprüche 1 bis 3, **dadurch gekennzeichnet, dass** die Filtervorrichtung (LPF) mindestens einen Polarisationsmagneten (PM) aufweist, dessen Nord- und Südpol ausgerichtet sind, um die umgekehrte Vorpolarisation einzuführen.

5. Kombination nach Anspruch 4, **dadurch gekennzeichnet, dass** die Filtervorrichtung (LPF) ferner ein Polstück (PP) aufweist, das zwischen dem axialen Kern (C) und dem Polarisationsmagneten (PM) angeordnet ist.

6. Kombination nach Anspruch 5, **dadurch gekennzeichnet, dass** sich zwischen dem Polstück (PP) und dem Joch (YO) ein Luftspalt (AG) befindet.

7. Kombination nach einem der Ansprüche 1 bis 3, **dadurch gekennzeichnet, dass** die Filtervorrichtung (LPF) mindestens eine Polarisationswicklungsschaltung (PW) aufweist.

8. Kombination nach Anspruch 7, **dadurch gekennzeichnet, dass** die Polarisationswicklungsschaltung (PW) um den axialen Kern (C) angeordnet ist, wobei die Polarisationswicklungsschaltung (PW) in der entgegengesetzten Richtung der Primärwicklungsschaltung (W1) gewickelt ist.

9. Kombination nach Anspruch 8, **dadurch gekennzeichnet, dass** die Polarisationswicklungsschaltung (PW) dazu bestimmt ist, zwischen einer negativen Anschlussklemme (B-) einer Batterie und einem Startkontakt (CS) des Fahrzeugs angeschlossen zu werden.

## Claims

1. Combination (1) in an electric starter circuit of a motor vehicle of a starter (DCM, EC) and of a battery voltage step-up device (LPF), said starter (DCM, EC) comprising an electric motor (DCM) and an electromagnetic contactor (EC), said battery voltage step-up device (LPF) being intended to prevent a drop in the battery voltage (Vbat) following a current spike produced by the switching on in a power circuit of said starter (DCM, EC), **characterized in that** said battery voltage step-up device (LPF) consists of a filtering device of inductive type (LPF) which is mounted in series with said electric motor (DCM) in said power circuit, said filtering device comprising a magnetic circuit (YO, C) with reverse pre-biasing and a field frame (YO, C) made of magnetic material comprising a cylindrical yoke (YO) and an axial core (C) around which are arranged a primary winding circuit (W1) intended to be inserted in series in said power circuit and a short-circuited secondary winding circuit (W2).

2. Combination according to Claim 1, **characterized in that** said filtering device (LPF) is inserted into said starter power circuit (DCM, EC) between a positive terminal (B+) of a battery of said vehicle and a power contact (CP) of said electromagnetic contactor (EC).

3. Combination according to Claim 1, **characterized in that** said filtering device (LPF) is inserted into said starter power circuit (DCM, EC) between a power contact (CP) of said electromagnetic contactor (EC) and said electric motor (DCM).

4. Combination according to any one of Claims 1 to 3, **characterized in that** said filtering device (LPF) comprises at least one bias magnet (PM) whose north and south poles are oriented in such a way as to introduce said reverse pre-bias.

5. Combination according to Claim 4, **characterized in that** said filtering device (LPF) furthermore comprises a polar part (PP) that is arranged between said axial core (C) and said bias magnet (PM).

6. Combination according to Claim 5, **characterized in that** there is an air gap (AG) between said polar part (PP) and said yoke (YO).

7. Combination according to any one of Claims 1 to 3, **characterized in that** said filtering device (LPF) comprises at least one bias winding circuit (PW).

8. Combination according to Claim 7, **characterized in that** said bias winding circuit (PW) is arranged around said axial core (C), said bias winding circuit (PW) being wound in the direction opposite to said primary winding circuit (W1).

9. Combination according to Claim 8, **characterized in that** said bias winding circuit (PW) is intended to be connected between a negative terminal (B-) of a battery and a starter contact (CS) of said vehicle.
